# Europäisches Patentamt

# European Patent Office

# Office européen des brevets

(11) Veröffentlichungsnummer: **0 086 431**
A2

(12) # EUROPÄISCHE PATENTANMELDUNG

(21) Anmeldenummer: 83101146.5

(22) Anmeldetag: 07.02.83

(51) Int. Cl.³: **H 01 J 37/06, H 01 J 37/28**

(30) Priorität: 12.02.82 DE 3204897

(43) Veröffentlichungstag der Anmeldung: 24.08.83
Patentblatt 83/34

(84) Benannte Vertragsstaaten: **DE FR GB NL**

(71) Anmelder: **SIEMENS AKTIENGESELLSCHAFT, Berlin
und München Wittelsbacherplatz 2,
D-8000 München 2 (DE)**

(72) Erfinder: **Lischke, Burkhard, Prof. Dr. Ing., In der
Heuluss 13, D-8000 München 82 (DE)**
Erfinder: **Froslen, Jürgen, Dr. Ing., An der Ottosäule 18,
D-8012 Ottobrunn (DE)**
Erfinder: **Plies, Erich, Dr. rer. nat., Deisenhofener
Strasse 79 c, D-8000 München 90 (DE)**
Erfinder: **Schmitt, Reinhold, Dipi.-Ing.,
Tucholskystrasse 18, D-8000 München 83 (DE)**
Erfinder: **Weyl, Reinhard, Dr. rer. nat., Waldstrasse 16,
D-8019 Assling (DE)**

(54) Korpuskularstrahlerzeugendes System und Verfahren zu seinem Betrieb.

(57) Ein korpuskularstrahlerzeugendes System mit einem Teilsystem, welches aus zumindest einer korpuskelemittierenden Elektrode (K) und einer korpuskelbeschleunigenden Elektrode (A) besteht, soll bei hohen und niedrigen Beschleunigungsspannungen unter optimalen Bedingungen betrieben werden können. Dies wird durch eine zusätzliche nachgeschaltete Elektrode (B) ermöglicht, wobei das Teilsystem für eine bestimmte Korpuskularstrahlenergie optimal eingestellt ist und zur Erzielung unterschiedlicher Korpuskularstrahlenergien die Potentialdifferenz ($U_2$) zwischen dem Teilsystem und der zusätzlichen nachgeschalteten Elektrode (B) auf unterschiedliche Werte einstellbar ist. Solch ein korpuskularstrahlerzeugendes System ermöglicht ein aufladungsfreies Abbilden bzw. eine aufladungsfreie Messung isolierender Oberflächen.

0086431

SIEMENS AKTIENGESELLSCHAFT
Berlin und München

Unser Zeichen
VPA
82 P 1090 E

Korpuskularstrahlerzeugendes System und Verfahren zu
seinem Betrieb.

Die Erfindung betrifft ein korpuskularstrahlerzeugendes System nach dem Oberbegriff des Anspruchs 1 und ein Verfahren zu seinem Betrieb.

In der Rasterelektronenmikroskopie wird üblicherweise mit Strahlenergien von etwa 25 bis 30 keV gearbeitet. Bei der rasterelektronischen oder meßtechnischen Untersuchung mikroelektronischer Bauelemente ist dies unerwünscht, da sich isolierende Materialien aufladen und die Bauteile durch die hochenergetische Strahlung geschädigt werden. Wählt man die Strahlenergie hinreichend niedrig, so lassen sich Aufladungen vermeiden, weil man dann erreichen kann, daß die Zahl der auf das Meßobjekt einfallenden Elektronen gleich der Zahl der das Meßobjekt verlassenden Elektronen ist. Ebenso lassen sich bei hinreichend niedrigen Strahlenergien Strahlenschäden vermeiden.

Bekannte korpuskularstrahlerzeugende Systeme bestehen aus einer elektronenemittierenden Kathode und einer elektronenbeschleunigenden Anode. Dabei wird gewöhnlich der Elektronenstrahl durch eine Wehnelt-Elektrode gesteuert (R. Shimizu et al, Chicago: IIT Research Institute, Scanning Electron Microscopy, 1979, I, 11-18). Um bei einer gegebenen Beschleunigungsspannung des elektronenstrahlerzeugenden Systems einen optimalen Richtstrahlwert zu erhalten, müssen Abstände und Bohrungen des elektronenstrahlerzeugenden Systems entsprechend gewählt werden. Wird die Beschleunigungsspannung verändert, so müssen

My 1 Bla / 3.2.1982

BAD ORIGINAL

0086431

die geometrischen Abmessungen des elektronenstrahlerzeugenden Systems der aktuellen Beschleunigungsspannung jeweils neu angepaßt werden. Man könnte sich in der Praxis dadurch behelfen, daß man für niedrige Beschleunigungsspannungen den Abstand der Wehnelt-Elektrode zur Anode verringert. Ein solches Verfahren wäre jedoch umständlich, der Betrieb des elektronenstrahlerzeugenden Systems wäre bei einem solchen Behelf nicht optimal und ein Übergang von niedrigen Beschleunigungsspannungen auf höhere Beschleunigungsspannungen wäre nur dadurch möglich, daß der Abstand der Wehnelt-Elektrode zur Anode wieder vergrößert werden würde. Eine jede Veränderung des Abstands der Wehnelt-Elektrode zur Anode würde jedoch jeweils ein Belüften des elektronenstrahlerzeugenden Systems notwendig machen. Die optimale Einstellung eines bekannten elektronenstrahlerzeugenden Systems für niedrige Beschleunigungsspannungen erfordert nicht nur eine optimale Geometrie dieses elektronenstrahlerzeugenden Systems, sondern ist noch zusätzlich dadurch erschwert, daß der Abstand der Wehnelt-Elektrode zur Anode wegen der notwendigen Spannungsfestigkeit nicht beliebig klein werden darf.

Der vorliegenden Erfindung liegt die Aufgabe zugrunde, ein korpuskularstrahlerzeugendes System der eingangs genannten Art anzugeben, welches bei hohen und niedrigen Beschleunigungsspannungen unter optimalen Bedingungen betrieben werden kann, welches den Betrieb eines von der Korpuskularstrahlenergie unabhängigen Austastsystems ermöglicht und welches ein aufladungsfreies Abbilden bzw. eine aufladungsfreie Messung isolierender Oberflächen ermöglicht.

Diese Aufgabe wird erfindungsgemäß durch ein korpuskularstrahlerzeugendes System der eingangs genannten Art ge-

0086431

löst, welches die kennzeichnenden Merkmale des Anspruchs 1 aufweist.

Ein erfindungsgemäßes korpuskularstrahlerzeugendes System ermöglicht sowohl bei hohen als auch bei niedrigen Beschleunigungsspannungen einen optimalen Richtstrahlwert und eine optimale Zentrierung. Mit einem erfindungsgemäßen korpuskularstrahlerzeugenden System ist ein aufladungsfreies Abbilden bzw. eine aufladungsfreie Messung isolierender Oberflächen möglich, wobei sich dieses aufladungsfreie Abbilden bzw. aufladungsfreie Messung isolierender Oberflächen mit einfachen Mitteln automatisieren läßt.

Ausgestaltungen und Vorteile der Erfindung sind in den Unteransprüchen, der Beschreibung und der Zeichnung dargestellt.

Die Erfindung wird im folgenden anhand der Zeichnung näher beschrieben.

Fig.1 zeigt ein erfindungsgemäßes korpuskularstrahlerzeugendes System mit Nachverzögerung.

Fig.2 erläutert den Betrieb eines korpuskularstrahlerzeugenden Systems nach Fig.1.

Fig.3 zeigt ein erfindungsgemäßes korpuskularstrahlerzeugendes System mit Nachbeschleunigung.

Fig.4 erläutert den Betrieb eines korpuskularstrahlerzeugenden Systems nach Fig.3.

Fig.5 zeigt ein erfindungsgemäßes korpuskularstrahlerzeugendes System mit Nachbeschleunigung und Austastsystem.

0086431

Fig.6 erläutert den Betrieb eines korpuskularstrahlerzeugenden Systems nach Fig.5.

Fig.7 zeigt ein erfindungsgemäßes korpuskularstrahlerzeugendes System mit einer Multipol-Wehnelt-Elektrode.

Fig.8 zeigt eine Multipol-Wehnelt-Elektrode, welche für
ein korpuskularstrahlerzeugendes System nach Fig.7
verwendet werden kann.

Fig.9 zeigt eine Ansteuerung zur Korpuskularstrahljustierung.

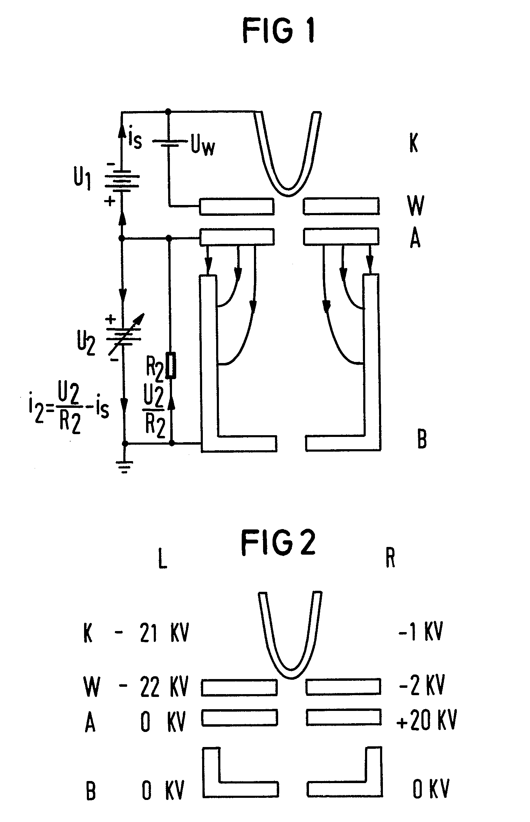

Fig.1 zeigt ein erfindungsgemäßes korpuskularstrahlerzeugendes System mit Nachverzögerung. Im folgenden werden zwar elektronenstrahlerzeugende Systeme näher beschrieben, entsprechende strahlerzeugende Systeme können
jedoch auch für Ionenquellen benutzt werden. Der Betrieb
eines elektronenstrahlerzeugenden Systems nach Fig.1 ist
in Fig.2 näher erläutert. Die in Fig.2 in den Spalten L,
R angegebenen Spannungswerte mögen nur als Beispiel dienen. Die Elektronen werden von der Kathode K zur Anode
A beschleunigt. Die Wehnelt-Elektrode W dient zur Strahlfokussierung. Werden die Elektroden des elektronenstrahlerzeugenden Systems mit den in Spalte L angegebenen Spannungswerten beaufschlagt, nämlich die Kathode K mit -21 kV,
die Wehnelt-Elektrode mit -22 kV und die Anode A mit 0 kV,
so beeinflußt eine zusätzliche nachgeschaltete Blende
(Elektrode) B den Elektronenstrahl nicht, sofern diese
zusätzliche nachgeschaltete Blende B mit einer Spannung
von 0 kV angesteuert wird. Die Abstände und Bohrungen
des elektronenstrahlerzeugenden Systems nach Fig.1 mögen
so gewählt sein, daß sich bei der Aufladung der Elektroden des elektronenstrahlerzeugenden Systems mit den in
der Spalte L angegebenen Spannungswerten optimale Feldstärken und damit ein optimaler Richtstrahlwert einstellen. Werden nun die ein Teilsystem des elektronenstrahlerzeugenden Systems bildenden drei Elektroden, nämlich Kathode K, Wehnelt-Elektrode W und Anode A, mit den in der Spalte R der Fig.2 angegebenen Spannungswerten angesteuert, wobei die Spannungswerte der drei Elektroden dieses Teilsystems in der Spalte R der Fig.2 gegenüber den Spannungswerten in der Spalte L der Fig.2 jeweils um +20 kV erhöht sind, so erhält man innerhalb dieses Teilsystems die gleichen Potentialdifferenzen, die gleichen Feldstärken und den gleichen Richtstrahlwert sowohl bei den Spannungswerten nach der Spalte L der Fig.2 als auch mit den Spannungswerten nach der Spalte R der Fig.2. Werden nun aber bei einem Betrieb nach der Spalte R der Fig.2 die Elektronen durch die auf 0 kV befindliche Blende B abgebremst, so beträgt die Elektronenenergie nach Verlassen des elektronenstrahlerzeugenden Systems nur noch 1 keV, da bei einem Betrieb nach der Spalte R der Fig.2 die Potentialdifferenz zwischen Kathode K und Blende B 1 kV beträgt. Mit den festen Spannungen $U_1$ zwischen Kathode K und Anode A und $U_W$ zwischen Kathode K und Wehnelt-Elektrode W wird das Teilsystem also für eine bestimmte Elektronenstrahlenergie optimal eingestellt und durch die variable Zusatzspannung $U_2$ zwischen Anode A und Blende B wird der Elektronenstrahl auf die gewünschte Elektronenstrahlenergie abgebremst. Eine geeignet ausgelegte Spannungsversorgung $U_2$ oder Zusatzwiderstände $R_2$ sorgen dafür, daß das Konstantspannungsgerät $U_2$ nicht in Sperrichtung durch einen Strom belastet wird. Werden umschaltbare Spannungsbereiche $U_2$ gewählt, so kann damit jeweils auch der Widerstand $R_2$ günstig angepaßt werden. Erstreckt sich beispielsweise ein erstes Spannungsintervall $U_2$ von 21 kV bis 15 kV, beträgt der von der Anode A zur Kathode K fließende Strom $i_s$ $10^{-3}$A, weist der Widerstand $R_2$ einen Wert von 15 MΩ auf, so beträgt der

durch den Widerstand $R_2$ fließende Strom $U_2/R_2$ 1,4 mA für $U_2$ = 21 kV und der über das Spannungsgerät $U_2$ fließende Strom $i_2 = U_2/R_2 - i_s$   0,4 mA.  Als Leistung des Spannungsgerätes $U_2$ sind dann ca. 30 W erforderlich, die Elektronenstrahlenergie ist dabei variabel von 0 keV bis 6 keV.  Mit einem erfindungsgemäßen elektronenstrahlerzeugenden System kann die Elektronenstrahlenergie im gesamten Bereich bis nahezu 0 eV varriiert werden.  Eine Anordnung nach Fig.1 erweist sich insbesondere bei kleinsten Elektronenstrahlenergien als vorteilhaft, da bei in üblicher Weise hergestellten elektronenstrahlerzeugenden Systemen aufgrund der mechanischen Toleranzen bei kleinen Elektronenstrahlenergien nicht mehr die hohen, für einen optimalen Betrieb erforderlichen Feldstärken im Kathodenraum erzeugt werden können.

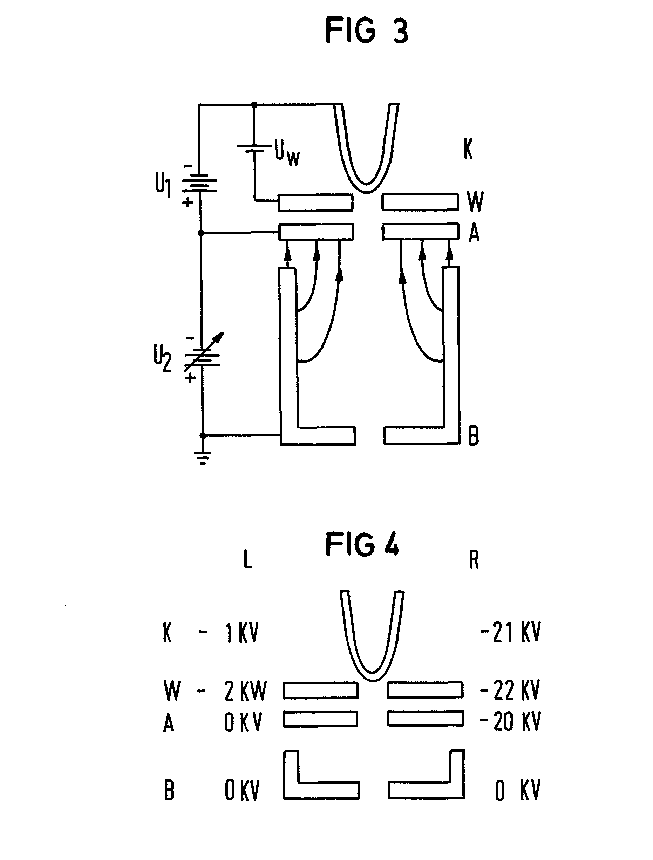

Fig.3 zeigt ein erfindungsgemäßes elektronenstrahlerzeugendes System mit Nachbeschleunigung.  Fig.4 erläutert den Betrieb eines elektronenstrahlerzeugenden Systems nach Fig.3 in entsprechender Weise dazu, wie in Fig.2 der Betrieb eines elektronenstrahlerzeugenden Systems nach Fig.1 erläutert worden ist.  Beispielsweise wird ein elektronenstrahlerzeugendes System nach Fig.3 für Spannungswerte, wie sie in der Spalte L von Fig.4 angegeben sind, optimiert, nämlich für eine Kathodenspannung von -1 kV, eine Wehnelt-Elektrodenspannung von -2 kV und eine Anodenspannung von 0 kV.  Werden die in Spalte R von Fig.4 angegebenen Spannungswerte angewandt, nämlich eine Kathodenspannung von -21 kV, eine Wehnelt-Elektrodenspannung von -22 kV und eine Anodenspannung von -20 kV, so werden die Elektronen durch die jeweils auf 0 kV liegende Blende B nachbeschleunigt.  Bei einem elektronenstrahlerzeugenden System nach Fig.3 sind durch Nachbeschleunigung ebenfalls variable Elektronenstrahlenergien einstellbar.  Bei einem elektronenstrahlerzeugenden System nach Fig.3 ist jedoch zu beachten, daß eine Mindest-Elektronenstrahlenergie für $U_2$ = 0 kV nicht unterschritten werden darf und daß eine optimale Dimensionierung des elektronenstrahlerzeugenden Systems bei sehr kleinen Spannungen problematisch sein kann. Bei einem elektronenstrahlerzeugenden System nach Fig.3 sind Zusatzwiderstände $R_2$, wie sie in Fig.1 dargestellt sind, auch nicht alternativ in Betracht zu ziehen.

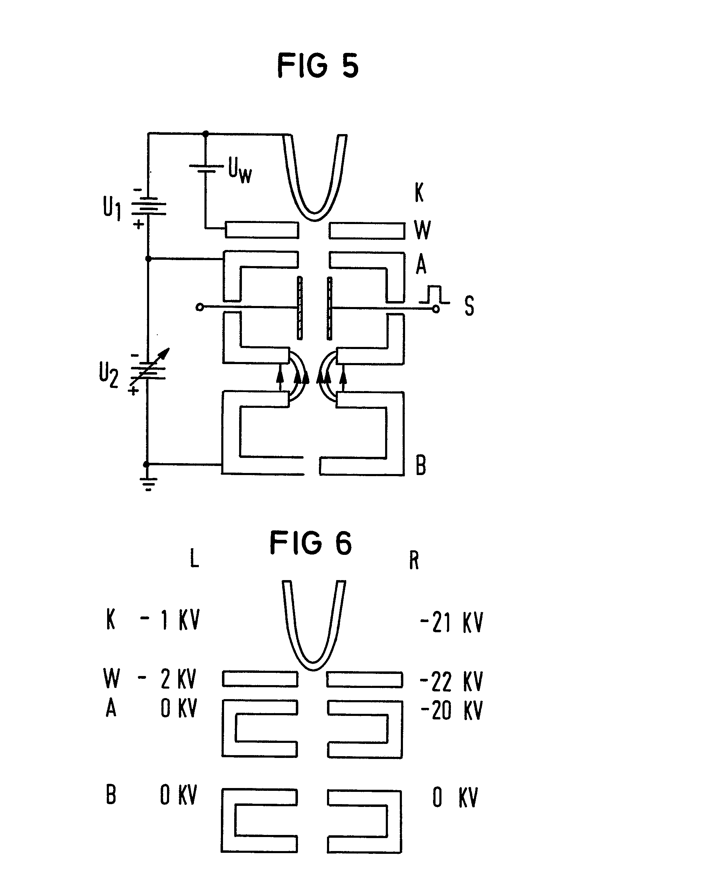

Fig.5 zeigt ein erfindungsgemäßes elektronenstrahlerzeugendes System mit Nachbeschleunigung und Austastsystem. Fig.6 erläutert den Betrieb eines elektronenstrahlerzeugenden Systems nach Fig.5. Im Vergleich zu einem elektronenstrahlerzeugenden System nach Fig.1 bzw. nach Fig.3 ist bei einem elektronenstrahlerzeugenden System nach Fig.5 die Lage der Nachbeschleunigungs- bzw. Nachverzögerungslinse in größerer Entfernung von der Kathode K angeordnet. Dadurch ist es möglich, die Anode A als einen Faraday-Käfig auszubilden, in dessen Innerem ein Austastsystem S zur Abschaltung des Elektronenstrahls angebracht ist. Dieses Austastsystem S kann für eine einzige Elektronenstrahlspannung optimal ausgelegt werden, da die Beschleunigung oder Verzögerung des Elektronenstrahls auf die gewünschte Elektronenstrahlenergie erst hinter dem Austastsystem S erfolgt. Das zu Fig.4 über den Betrieb eines elektronenstrahlerzeugenden Systems nach Fig.3 Gesagte gilt entsprechend zu Fig.6 für den Betrieb eines elektronenstrahlerzeugenden Systems nach Fig.5. Ein elektronenstrahlerzeugendes System nach Fig.5 kann anstelle einer Nachbeschleunigung auch eine Nachverzögerung entsprechend einem elektronenstrahlerzeugenden System nach Fig.1 aufweisen.

Fig.6 zeigt ein erfindungsgemäßes elektronenstrahlerzeugendes System mit einer Multipol-Wehnelt-Elektrode W.

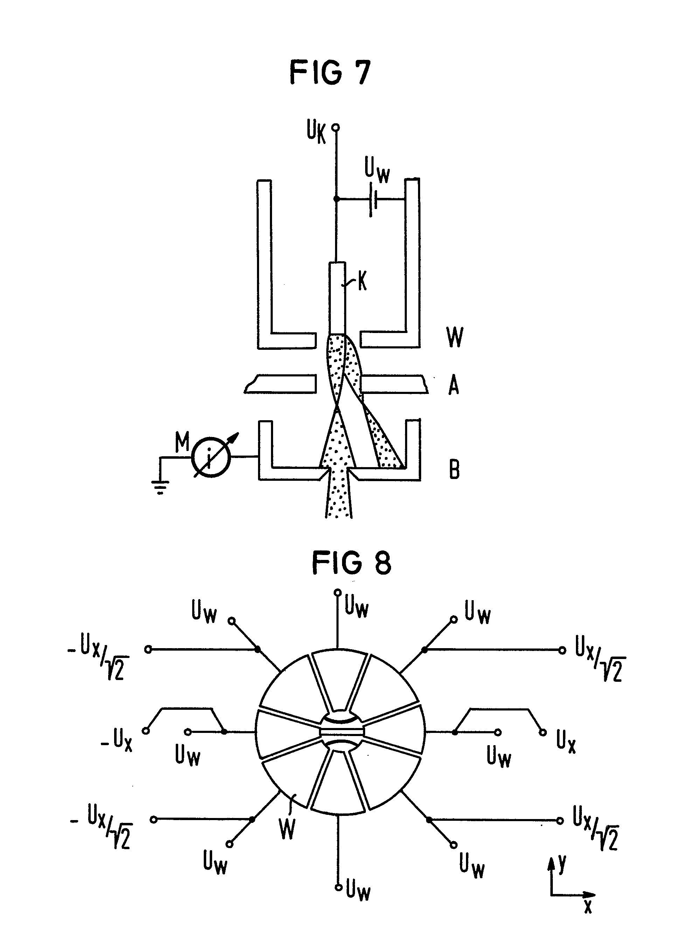

Eine Anordnung nach Fig.7 ermöglicht eine Strahlzentrierung. In Fig.8 ist gezeigt, wie mit einer in Sektoren aufgeteilten Wehnelt-Elektrode W sich ein Ablenkfeld in x-Richtung erzeugen läßt. Wie in der deutschen Offenlegungsschrift 30 10 815.7 näher dargestellt ist, kann durch geeignete Zusatzpotentiale zur Wehneltspannung $U_W$ der Elektronenstrahl zur Justierung verschoben, ganz ausgetastet oder auch astigmatisch geformt werden. Die Detektion des Elektronenstrahls erfolgt über den über die Blende B fließenden Strom i, wobei es günstig ist, wenn der Lochblendendurchmesser größer oder gleich dem Elektronenstrahldurchmesser gewählt wird. Der Strom i wird mit einem Strommeßgerät M als Elektronenstrahldetektor nachgewiesen. Die Kathode K wird mit einer Spannung $U_K$ angesteuert. Wird die Elektronenstrahljustierung bei hoher Elektronenstrahlenergie durchgeführt, so bleibt diese Strahljustierung auch bei kleinen Elektronenstrahlenergien erhalten.

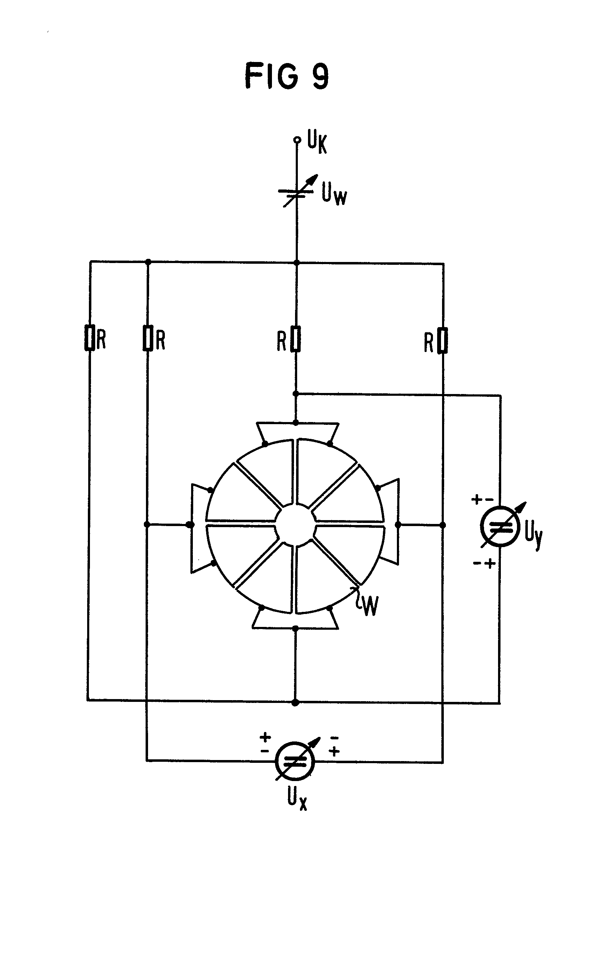

Fig.9 zeigt eine Ansteuerung zur Strahljustierung nach Fig.7 und Fig.8. In Fig.9 ist dargestellt, wie die Elektronenstrahljustierung in einfacher Weise elektrisch realisiert werden kann. Zwei Spannungsgeräte $U_x$, $U_y$ liefern die Ablenkspannungen für die x- und y-Richtung (siehe die erwähnte DE-OS 30 10 815.7), wobei diese Ablenkspannungen solange variiert werden, bis das Elektronenstrahl-Strommeßgerät M ein Minimum anzeigt. Der Elektronenstrahl ist dann auf die optische Achse justiert. Die Wehnelt-Spannung $U_W$ wird zur optimalen Strahljustierung im Verhältnis zur Kathodenspannung $U_K$ ebenfalls variiert.

Mit erfindungsgemäßen elektronenstrahlerzeugenden Systemen ist die aufladungsfreie Abbildung bzw. die aufladungsfreie Messung isolierender Oberflächen möglich, da sich die Elektronenstrahlenergie dabei kontinuierlich variieren läßt. Bei bestimmten Elektronenstrahlenergien beträgt die Summe aus Rückstreukoeffizient und Sekundärelektronenausbeute den Wert 1. An diesen sogenannten Neutralpunkten ist die Zahl der das Meßobjekt verlassenden Elektronen gleich der Zahl der auf das Meßobjekt einfallenden Elektronen. In allen anderen Fällen lädt sich das Meßobjekt auf das Potential $V_p$ auf, wodurch im Meßobjekt ein Probenstrom $i_p = V_p/R_p$ fließt. Beträgt der Ableitwiderstand $R_p$ der Probe z.B. 1 M$\Omega$ und die Aufladung $V_p$ 1 V, so fließt ein Probenstrom $i_p$ von einem Mikroampere. Dieser Probenstrom $i_p$ kann benutzt werden, um die Hochspannung $U_2$ so einzustellen, daß eine aufladungsfreie Abbildung bzw. Messung der isolierenden Oberflächen möglich ist. Für höhere Elektronenstrahlenergien oberhalb des sogenannten zweiten Neutralpunktes lädt sich die Probe negativ auf, unterhalb dieses sogenannten zweiten Neutralpunktes lädt sich die Probe positiv auf. Der Probenstrom $i_p$ wird nicht nur Null, sondern wechselt auch sein Vorzeichen, so daß die Hochspannung $U_2$ nach Richtung und Größe schnell eingestellt werden kann. Dieser Einstellvorgang der Hochspannung $U_2$ läßt sich in einfacher Weise automatisieren, so daß die Elektronenstrahlenergie automatisch für eine aufladungsfreie Abbildung bzw. Messung eingestellt werden kann. Für ein solches automatisches Verfahren ist der Strom $i_p$ die Stellgröße für die Hochspannung $U_2$.

Die beschriebenen körpuskularstrahlerzeugenden Systeme sind nicht nur bei negativen Wehnelt-Spannungen anwendbar, sondern gelten entsprechend auch bei positiven Wehnelt-Spannungen. Entsprechende Anordnungen können auch für Ionenquellen benutzt werden.

Eine Multipol-Wehnelt-Elektrode W ist in mindestens zwei Segment-Elektroden aufgeteilt, welche voneinander isoliert sind und mit beliebigen Spannungen U angesteuert werden können.

Für die folgenden Darlegungen wird ein kartesisches Koordinatensystem (x-Achse, y-Achse) zugrunde gelegt. Dann kann beispielsweise bei Forderung nach möglichst ebenen Äquipotentialflächen des von den Segment-Elektroden zur Fokussierung des Korpuskularstrahls erzeugten Feldes eine Segment-Elektrode der Multipol-Wehnelt-Elektrode W, welche etwa bei einem Winkel $\vartheta$ angeordnet ist, wobei der Winkel von der positiven x-Halbachse aus in Richtung zur positiven y-Halbachse gemessen wird, etwa mit folgender Spannung U angesteuert werden:

$$U = U_W + U_x \cdot \cos \vartheta + U_y \cdot \sin \vartheta + \sum_{m=2}^{3} \left[ U_{mc} \cdot \cos (m\vartheta) + U_{ms} \cdot \sin (m\vartheta) \right]$$

mit

$U_W$ ............. Wehnelt-Spannung
$U_x$, $U_y$ ......... Ablenkspannungen
$U_{mc}$, $U_{ms}$ ....... Stigmatorspannungen
$m$ ............. Zähligkeit des Stigmatorfeldes.

Gemäß dieser Gleichung für die Spannungsversorgung von Segment-Elektroden können beispielsweise eine Achtpol-Wehnelt-Elektrode W mit einem beliebig in Stärke und Azimutlage variierbaren 2-zähligen und 3-zähligen Sigmatorfeld angesteuert werden. Bei Wahl einer Sechspol-Wehnelt-Elektrode W können die sechs Segment-Elektroden ebenfalls gemäß obiger Gleichung mit Spannungen beaufschlagt werden, wobei mit $U_{3c} = U_{3s} = 0$ eine in der Stärke veränderliches und beliebig drehbares 2-zähliges Stigmatorfeld erzeugt werden kann.

Die Elektrodenspannungen zur dynamischen Strahlaustastung sind in obiger Gleichung nicht erfaßt. Da zur Strahlaustastung nicht unbedingt ein homogenes Feld benötigt wird,

0086431

können einige entsprechend gewählte nebeneinanderliegende Segment-Elektroden mit der Spannung $+U_A$ und einige
diesen Segment-Elektroden gegenüberliegende Segment-
Elektroden mit der Spannung $-U_A$ zur Strahlaustastung
beaufschlagt werden.

Patentansprüche:

1. Korpuskularstrahlerzeugendes System mit einem Teilsystem, bestehend aus zumindest einer korpuskelemittierenden Elektrode (K) und einer korpuskelbeschleunigenden Elektrode (A), g e k e n n z e i c h n e t durch eine zusätzliche nachgeschaltete Elektrode (B), wobei das Teilsystem für eine bestimmte Korpuskularstrahlenergie optimal eingestellt ist und zur Erzielung unterschiedlicher Korpuskularstrahlenergien die Potentialdifferenz ($U_2$) zwischen dem Teilsystem und der zusätzlichen nachgeschalteten Elektrode (B) auf unterschiedliche Werte einstellbar ist.

2. Korpuskularstrahlerzeugendes System nach Anspruch 1, g e k e n n z e i c h n e t durch optimale Bemessung des Teilsystems für hohe Spannungen (Fig.1).

3. Korpuskularstrahlerzeugendes System nach Anspruch 1, g e k e n n z e i c h n e t durch optimale Bemessungen des Teilsystems für niedrige Spannungen (Fig.3, 5).

4. Korpuskularstrahlerzeugendes System nach Anspruch 1 bis 3, dadurch g e k e n n z e i c h n e t , daß die korpuskelbeschleunigende Elektrode (A) als ein Faraday-Käfig ausgebildet ist, in dessen Innerem ein Austastsystem (S) zur Abschaltung des Korpuskularstrahls angebracht ist (Fig.5).

5. Korpuskularstrahlerzeugendes System nach Anspruch 1 bis 4, dadurch g e k e n n z e i c h n e t , daß das Teilsystem eine Wehnelt-Elektrode (W) aufweist, wobei die Wehnelt-Elektrode (W) gemäß DE-OS 30 10 815.7 in Sektoren aufgeteilt und zusätzlich zur Wehnelt-Spannung ($U_W$) mit mindestens einer weiteren Zusatzspannung ($U_x$; $U_y$) ansteuerbar ist (Fig.8).

6. Verfahren zum Betrieb eines korpuskularstrahlerzeugenden Systems nach Anspruch 1 bis 5, dadurch g e - k e n n z e i c h n e t , daß die Potentialdifferenz $(U_2)$ zwischen dem Teilsystem und der zusätzlichen nachgeschalteten Elektrode zur Erzielung verschiedener Korpuskularstrahlenergien variiert wird.

7. Verfahren zum Betrieb eines korpuskularstrahlerzeugenden Systems nach Anspruch 1 bis 6, dadurch g e - k e n n z e i c h n e t , daß der Korpuskularstrahl über den über die nachgeschaltete Elektrode (B) fließenden Strom (i) detektiert wird.

8. Verfahren zum Betrieb eines korpuskularstrahlerzeugenden Systems nach Anspruch 1 bis 7, dadurch g e - k e n n z e i c h n e t , daß die Korpuskularstrahljustierung bei hoher Korpuskularstrahlenergie erfolgt.

9. Verfahren zum Betrieb eines korpuskularstrahlerzeugenden Systems nach Anspruch 1 bis 8, dadurch g e - k e n n z e i c h n e t , daß die zumindest eine Zusatzspannung $(U_x; U_y)$ an der Wehnelt-Elektrode (W) solange variiert wird, bis ein Korpuskularstrahlmeßgerät (M), welches den über die nachgeschaltete Elektrode (B) fließenden Strom (i) detektiert, einen Extremwert zeigt. (Fig.9).

10. Verfahren zum Betrieb eines korpuskularstrahlerzeugenden Systems nach Anspruch 1 bis 9, dadurch g e - k e n n z e i c h n e t , daß zur aufladungsfreien Abbildung oder Messung von Potentialen an isolierenden Oberflächen die Korpuskularstrahlenergie solange kontinuierlich variiert wird, bis die Zahl der das Objekt verlassenden Korpuskeln gleich der Zahl der auf das Objekt einfallenden Korpuskeln ist.

11. Verfahren zum Betrieb eines korpuskularstrahlerzeugenden Systems nach Anspruch 10, dadurch g e k e n n - z e i c h n e t , daß die Korpuskularstrahlenergie solange variiert wird, bis der vom Korpuskularstrahl hervorgerufene Probenstrom ($i_p$) verschwindet.

12. Verfahren zum Betrieb eines korpuskularstrahlerzeugenden Systems nach Anspruch 10 oder 11, dadurch g e - k e n n z e i c h n e t , daß die Korpuskularstrahlenergie automatisch für eine aufladungsfreie Abbildung oder Messung eingestellt wird.

0086431

1/5

FIG 1

FIG 2

# FIG 3

$U_W$

K

$U_1$

$-$
$+$

W

A

$U_2$

$-$
$+$

B

# FIG 4

L                    R

K   $-$ 1KV                    $-21$ KV

W   $-$ 2KW                    $-22$ KV
A   0KV                    $-20$ KV

B   0KV                    0 KV

**FIG 5**

**FIG 6**

| | L | | R |
|---|---|---|---|
| K | – 1 KV | | –21 KV |
| W | – 2 KV | | –22 KV |
| A | 0 KV | | –20 KV |
| B | 0 KV | | 0 KV |

0086431

4/5

## FIG 7

$U_K$

$U_W$

K

W

A

M

B

## FIG 8

$U_W$   $U_W$   $U_W$

$-U_X/\sqrt{2}$   $U_X/\sqrt{2}$

$-U_X$   $U_W$   $U_W$   $U_X$

$-U_X/\sqrt{2}$   W   $U_X/\sqrt{2}$

$U_W$   $U_W$

$U_W$

y

x

FIG 9